# EUROPÄISCHE PATENTSCHRIFT

(11) **EP 3 035 012 B1**
(45) Veröffentlichungstag und Bekanntmachung des Hinweises auf die Patenterteilung: **14.02.2018**
(21) Anmeldenummer: 15197783.2
(22) Anmeldetag: 03.12.2015
(51) Int. Cl.: H01L 31/0312, H01L 31/103, H01L 31/105, G01J 1/42

(54) **VERFAHREN, HALBLEITERDETEKTOR UND DETEKTORANORDNUNG ZUR DETEKTION VON SONNENLICHT**
METHOD, SEMICONDUCTOR DETECTOR AND A DETECTOR ASSEMBLY FOR DETECTION OF SUNLIGHT
PROCÉDÉ, DÉTECTEUR A SEMI-CONDUCTEUR ET AGENCEMENT DE DÉTECTION DU RAYONNEMENT SOLAIRE

(30) Priorität: 16.12.2014 DE 102014018722
(43) Veröffentlichungstag der Anmeldung: 22.06.2016
(73) Patentinhaber: Fraunhofer-Gesellschaft zur Förderung der angewandten Forschung e.V., 80686 München (DE)
(72) Erfinder: Erlbacher, Tobias, 91099 Poxdorf (DE)
(74) Vertreter: Gagel, Roland

(56) Entgegenhaltungen:
- FR-A1- 2 248 169
- US-A- 5 093 576
- US-A- 5 594 236
- US-B1- 7 863 647
- X. CHEN ET AL.: "High-performance 4H-SiC-based ultraviolet p-i-n photodetector", J. APPL. PHYS., Bd. 102, 024505, 2007, Seiten 024505-1-024505-3, XP012101316,

## Beschreibung

### Technisches Anwendungsgebiet

Die vorliegende Erfindung betrifft ein Verfahren zur Detektion von Sonnenlicht mit einer Detektoranordnung, die ein Ausgangssignal in Abhängigkeit von einfallendem Sonnenlicht liefert sowie einen bei dem Verfahren eingesetzten Halbleiterdetektor.

Die Detektion von einfallendem Sonnenlicht kann bspw. in Anwendungen erforderlich sein, in denen technische Vorrichtungen in Abhängigkeit vom Sonnenlicht oder dem Einfallswinkel des Sonnenlichts gesteuert werden. Ein Beispiel hierfür sind Klimaanlagen in Kraftfahrzeugen, für deren Steuerung neben der Innenraumtemperatur auch die Intensität des durch die Scheiben einfallenden Sonnenlichts herangezogen wird.

### Stand der Technik

So ist bspw. aus der US 6666493 B1 eine Detektoranordnung für die Detektion von Sonnenlicht bekannt, mit deren Hilfe ein elektronisch ansteuerbarer Abdunkelungsmechanismus in der Windschutzscheibe gesteuert wird. Das auf das Gesicht des Fahrers einfallende Sonnenlicht wird hierbei mit einer Infrarot-Kamera detektiert, deren Signal den Abdunkelungsmechanismus in der Windschutzscheibe aktiviert.

Die US 5594236 A beschreibt einen Sonnenlichtsensor, der als Halbleiterbauelement ausgeführt ist. Dieser Sonnenlichtsensor wird bevorzugt zur Bestimmung des Einfallswinkels von Sonnenlicht in Kraftfahrzeugen eingesetzt, um die Klimaanlage zu steuern. Als Beispiel für geeignete Halbleitermaterialien für die Detektion von Sonnenlicht werden hierbei Si, GaAs oder InP genannt. Halbleiterdetektoren aus diesen Materialien sind im sichtbaren Spektralbereich des Sonnenlichts sensitiv.

Neben den Detektoren für die Detektion von Sonnenlicht sind aus dem Stand der Technik auch UV-Detektoren bekannt, die nicht durch Sonnenlicht beeinflusst werden sollen und als "Sonnenlicht-blinde" (solar-blind) UV-Detektoren bezeichnet werden. So beschreiben bspw. X. Chen et al., "High-performance 4H-SiC-based ultraviolet p-i-n photodetector", J. Appl. Phys. 102 (2007), Seiten 024505-1 bis 024505-4, einen UV-Halbleiterdetektor aus SiC-Material, insbesondere aus 4H-SiC, für die Detektion von UV-Strahlung im Wellenlängenbereich von 240 nm bis 350 nm. Durch den Bandabstand des Halbleiters von etwa 3 eV werden Lichtquanten mit einer Wellenlänge oberhalb von 400 nm nicht absorbiert. Dieser Detektor wird von den Autoren bereits als "solar-blind" bezeichnet. Durch den Einsatz von zusätzlichen Filtern können dabei auch die Wellenlängenbereiche des Sonnenlichts oberhalb von etwa 300 nm ausgeblendet werden. Auch A. Vert et al., "Silicon carbide photomultipliers and avalanche photodiode arrays for ultraviolet and solar-blind light detection", IEEE Sensors 2009 Conference, Seiten 1893 bis 1896, beschreiben einen derartigen sonnenblinden UV-Detektor aus SiC.

Die eingangs angeführten Lösungen für die Detektion von Sonnenlicht erlauben jedoch keine ausreichende Unterscheidung zwischen Sonnenlicht und anderen Lichtquellen, wie bspw. Straßenlaternen oder den Scheinwerfern entgegenkommender Fahrzeuge. Dies gilt natürlich auch für andere Lichtquellen, wie bspw. Glühbirnen, Halogenlampen, Energiesparlampen, LEDs oder grüne und rote Laserpointer, die die herkömmliche Sonnenlichtdetektion ebenfalls stören können.

Die DE 24 21 063 C3 beschreibt ein Verfahren zur Detektion von Sonnenlicht, bei dem ein Detektor auf Basis von Zinn (IV)-Oxid eingesetzt wird, um selektiv UV-Licht im Wellenlängenbereich von nur 320 bis 360 nm zu erfassen. Die US 5 093 576 A beschreibt ein Verfahren zur Lichtdetektion, bei dem ein Detektor auf Basis von SiC eingesetzt wird. Die Dotierung der Absorberschicht ist dabei > 10¹⁵ cm⁻³.

Die Aufgabe der vorliegenden Erfindung besteht darin, ein Verfahren zur Detektion von Sonnenlicht anzugeben, das durch andere Lichtquellen nicht gestört wird und eine hohe Empfindlichkeit für die Sonnenlichtdetektion aufweist.

### Darstellung der Erfindung

Die Aufgabe wird mit dem Verfahren gemäß Patentanspruch 1 gelöst. Patentanspruch 9 gibt einen für das Verfahren ausgebildeten Halbleiterdetektor, Patentanspruch 15 eine vorteilhafte Detektoranordnung für die Durchführung des Verfahrens an. Vorteilhafte Ausgestaltungen des Verfahrens, des Halbleiterdetektors und der Detektoranordnung sind Gegenstand der abhängigen Patentansprüche oder lassen sich der nachfolgenden Beschreibung sowie den Ausführungs- und Anwendungsbeispielen entnehmen.

Bei dem hier vorgeschlagenen Verfahren wird eine Detektoranordnung eingesetzt, die nur für einen UV-Anteil des einfallenden Sonnenlichts sensitiv ist und ein Ausgangssignal liefert. Das Sonnenlicht wird dann anhand des Ausgangssignals der Detektoranordnung detektiert, das ein Maß für die Intensität des einfallenden Sonnenlichts ist. Das Verfahren zeichnet sich dadurch aus, dass in der Detektoranordnung wenigstens ein SiC-Halbleiterdetektor eingesetzt wird, bei dem das untere von zwei Halbleitergebieten, die den pn-Übergang des Halbleiterdetektors bilden, eine Dotierstoffkonzentration von < 1*10¹⁵ cm⁻³, vorzugsweise < 5*10¹⁴ cm⁻³, und eine Dicke aufweist, die größer als 50% der Weite der Raumladungszone im thermodynamischen Gleichgewicht, d.h. bei 0V Spannung am pn-Übergang, bei die Raumladungszone nicht begrenzender Dicke dieses Halbleitergebietes ist. Vorzugsweise beträgt die Dicke des unteren Halbleitergebietes mindestens 75%, besonders bevorzugt mindestens 100% der Weite der Raumladungszone im thermodynamischen Gleichgewicht, wie sie sich bei nicht begrenzender Dicke dieses Halbleitergebietes einstellen würde. Unter einer nicht begrenzenden Dicke ist hierbei eine Dicke des Halbleitergebietes zu verstehen, die die Ausdehnung bzw. Weite der Raumladungszone übersteigt.

Der pn-Übergang des SiC-Halbleiterdetektors wird somit in bekannter Weise durch zwei übereinander liegende Halbleitergebiete gebildet, die in der vorliegenden Patentanmeldung als oberes und unteres Halbleitergebiet bezeichnet werden. Das obere Halbleitergebiet stellt dabei das der zu detektierenden Strahlung zugewandte Halbleitergebiet des pn-Übergangs dar.

Durch die Detektion lediglich des UV-Anteils des Sonnenlichts wird die Detektion nicht mehr durch andere künstliche Lichtquellen gestört, deren UV-Anteil in der Regel nur weniger als 1% der emittierten Lichtintensität beträgt. Die Sonnenlichtdetektion kann damit mit höherer Zuverlässigkeit erfolgen als bei Detektoren, die im sichtbaren Wellenlängenbereich des Sonnenlichtspektrums sensitiv sind. Die vorgeschlagene Sonnenlichtdetektion ist auch wesentlich einfacher realisierbar als eine Spektralanalyse mit Hilfe eines Spektralanalysators. Durch die Wahl eines SiC-Halbleiterdetektors mit der angegebenen niedrigen Dotierstoffkonzentration in Verbindung mit einer ausreichend großen Dicke des unteren Halbleitergebiets, das vorzugsweise mittels Epitaxie auf einem hochdotierten Substrat aufgewachsen wird, wird ein hoher Anteil der Photonen im Wellenlängenbereich zwischen 300nm und 330nm in der Raumladungszone des pn-Übergangs absorbiert. Dies führt zu einer besonders hohen Sensitivität des Detektors in diesem Wellenlängenbereich und somit zur gewünschten hohen Sensitivität der Sonnenlichtdetektion. Das untere Halbleitergebiet weist hierbei vorzugsweise eine Dicke von mindestens 1,7 µm auf.

Durch das Anlegen einer Sperrspannung an den pn-Übergang lässt sich bei ausreichend großer Dicke des unteren Halbleitergebiets auch die Sensitivität zu Wellenlängen zwischen 330nm und 350nm (bis hin zu 380nm) weiter erhöhen. Dies geht dann allerdings auf Kosten der Nachweisgenauigkeit (Dunkelleckstrom).

Ein SiC-Halbleiterdetektor weist bereits eine deutlich höhere Empfindlichkeit im ultravioletten Spektralbereich gegenüber dem sichtbaren und infraroten Spektralbereich auf. Für die Sonnenlichtdetektion gemäß dem vorgeschlagenen Verfahren ist dann kein zusätzlicher Filter vor dem Detektor mehr erforderlich. Selbstverständlich kann jedoch auch zusätzlich noch ein derartiger Filter oder eine entsprechende Filteranordnung eingesetzt werden. Die Nutzung eines SiC-Halbleiterdetektors für die Sonnenlichtdetektion hat den Vorteil, dass derartige Detektoren eine hohe Stabilität bei UV-Bestrahlung sowie ein geringes Elektronenrauschen aufgrund des hohen Bandabstands aufweisen. Dies erlaubt den Betrieb dieser Detektoren bei Raumtemperaturen, während bei anderen Sensormaterialien je nach Anwendungszweck eine Kühlung notwendig sein kann. Damit liefern derartige Detektoren eine höhere Auflösung bzw. einen geringeren Dunkelleckstrom bei Raumtemperatur als bekannte im sichtbaren Spektralbereich empfindliche Sonnenlichtdetektoren, insbesondere aus Silizium. Durch die hohe Auflösungsfähigkeit eines SiC-Halbleiterdetektors ist grundsätzlich auch eine genauere Streulichtmessung von Sonnenlicht bzw. eine Messung bei noch größeren Streuwinkeln als bei anderen Sonnenlichtdetektoren möglich. Der Betrieb eines SiC-Halbleiterdetektors ist auch bei hohen Temperaturen (über 200°C) im Gegensatz zu ungekühlten Siliziumdetektoren möglich. Hohe Betriebstemperaturen ergeben sich bei der direkten Einstrahlung durch Sonnenlicht zwangsweise aus der Absorption der Sonnenenergie im Sensor oder in der Peripherie des Sensors.

Im Gegensatz zu der bekannten Nutzung von SiC-Haöbleiterdetektoren als UV-Detektoren, die Sonnenlicht-blind sein sollen, wird beim vorliegenden Verfahren gerade die Detektierbarkeit des UV-Anteils von Sonnenlicht ausgenutzt, um einen derartigen Detektor als Sonnenlichtdetektor einzusetzen.

In einer besonders vorteilhaften Ausgestaltung des vorgeschlagenen Verfahrens wird ein SiC-Halbleiterdetektor vom 4H-SiC Polytyp eingesetzt. Dieses Halbleitermaterial hat eine Leitungsbandkante bei 3,28eV und weist damit eine Absorptionskante bei ca. 378nm, die für die hier vorgeschlagene Detektion nur des UV-Anteils von Sonnenlicht besonders vorteilhaft ist.

Das obere Halbleitergebiet weist vorzugsweise eine Dotierstoffkonzentration von > 5*10¹⁸ cm⁻³, besonders bevorzugt > 1*10¹⁹ cm⁻³, auf. Damit wird ein guter ohmscher Kontakt für die elektrische Kontaktierung erreicht. Vorzugsweise wird die Schichtdicke des oberen Halbleitergebiets zwischen 1,5µm und 3µm gewählt, besonders bevorzugt zwischen 2µm und 3µm. Bei dieser Schichtdicke wird kurzwelliges Licht mit einer Wellenlänge unter 300nm bevorzugt im oberen Halbleitergebiet absorbiert, so dass die dadurch erzeugten Elektronen-Loch-Paare dort bereits rekombinieren, ohne zum Sensorsignal beizutragen. In einer vorteilhaften Ausgestaltung wird das obere Halbleitergebiet mittels Ionenimplantation erzeugt. Dies verbessert die Absorption im Bereich der Bandkante aufgrund von Z1/2-Defekten.

Für eine weitere Erhöhung der Effizienz kann der SiC-Halbleiterdetektor mit einer Antireflexbeschichtung versehen sein, die für einen Wellenlängenbereich zwischen 300 und 380nm ausgebildet ist. Hierzu kann das obere Halbleitergebiet beispielsweise mit einer Antireflexschicht aus SiO₂ beschichtet sein, die eine Dicke im Bereich zwischen 50nm bis 66nm aufweist. Der Detektor kann jedoch auch ohne Antireflexbeschichtung eingesetzt werden.

Der Detektor kann bei dem vorgeschlagenen Verfahren durch eine geeignete Aufbautechnik mit einem Silizium-CMOS-Chip kombiniert werden. Er kann in einem gehäusten oder ungehäusten Aufbau auf einer Platine montiert werden.

In einer weiteren vorteilhaften Ausgestaltung wird der für den UV-Anteil des Sonnenlichts sensitive SiC-Halbleiterdetektor mit einem weiteren Detektor kombiniert, der für den sichtbaren und/oder infraroten Spektralbereich des Sonnenlichts empfindlich ist, vorzugsweise ein relativ breites Spektrum im sichtbaren Spektralbereich detektiert. Durch geeignete Auswertung der Ausgangssignale der beiden Detektoren kann dann auch zwischen der direkten Einstrahlung von Sonnenlicht, der Einstrahlung einer UV-Licht emittierenden künstlichen Lichtquelle und der Einstrahlung einer nur im sichtbaren Spektralbereich emittierenden künstlichen Lichtquelle unterschieden werden. Bei direkter Einstrahlung von Sonnenlicht, das nicht durch eine Glasscheibe gefiltert wurde, liefern beide Detektoren ein entsprechendes Ausgangssignal. Wird lediglich im sichtbaren Spektralbereich ein Ausgangssignal geliefert, so kann dies entweder von einer künstlichen Lichtquelle oder von Sonnenlicht stammen, das durch eine Glasscheibe auf den Detektor gefallen ist und somit keinen UV-Anteil mehr aufweist. Wird lediglich UV-Licht detektiert, so muss dies zwangsläufig von einer künstlichen UV-Lichtquelle stammen. Der Einfall des Lichtes der unterschiedlichen Lichtquellen kann dabei bei entsprechender Kalibrierung der Detektoren auch quantifiziert werden. Der für den sichtbaren Spektralbereich empfindliche Detektor kann zusätzlich mit einem oder mehreren Filtern ausgestattet werden, die den UV-Anteil blockieren bzw. stark schwächen. Für diesen Detektor lassen sich bspw. Halbleiterdetektoren auf Basis von Si, GaP oder GaAs einsetzen.

Die bei dem Verfahren eingesetzte Detektoranordnung kann auch ein Detektorarray aus den entsprechenden Detektoren aufweisen, um dadurch ein Pixelarray zur ortsaufgelösten Messung, d. h. zur Lokalisierung des detektierten Lichts bzw. der Lichtquelle zu realisieren. Hierbei können auch die letztgenannten für den sichtbaren und/oder infraroten Spektralbereich empfindlichen Detektoren beliebig mit den SiC-Halbleiterdetektoren kombiniert werden, die lediglich den UV-Anteil des Sonnenlichts detektieren.

### Kurze Beschreibung der Zeichnungen

Das vorgeschlagene Verfahren wird nachfolgend anhand von Anwendungs- und Ausführungsbeispielen nochmals näher erläutert. Hierbei zeigen:
- Fig. 1: in stark schematisierter Darstellung ein Beispiel für den Aufbau einer Detektoranordnung für die Detektion von Sonnenlicht gemäß dem vorgeschlagenen Verfahren;
- Fig. 2: ein Beispiel für das Ausgangssignal (Stromstärke) des Detektors der vorgeschlagenen Detektoranordnung mit und ohne Bestrahlung durch unterschiedliche Lichtquellen;
- Fig. 3: in stark schematisierter Darstellung ein Beispiel für eine Detektoranordnung mit zwei Detektoren, die in unterschiedlichen Spektralbereichen sensitiv sind; und
- Fig. 4: ein Beispiel für den Aufbau des SiC-Halbleiterdetektors in schematischer Darstellung.

### Wege zur Ausführung der Erfindung

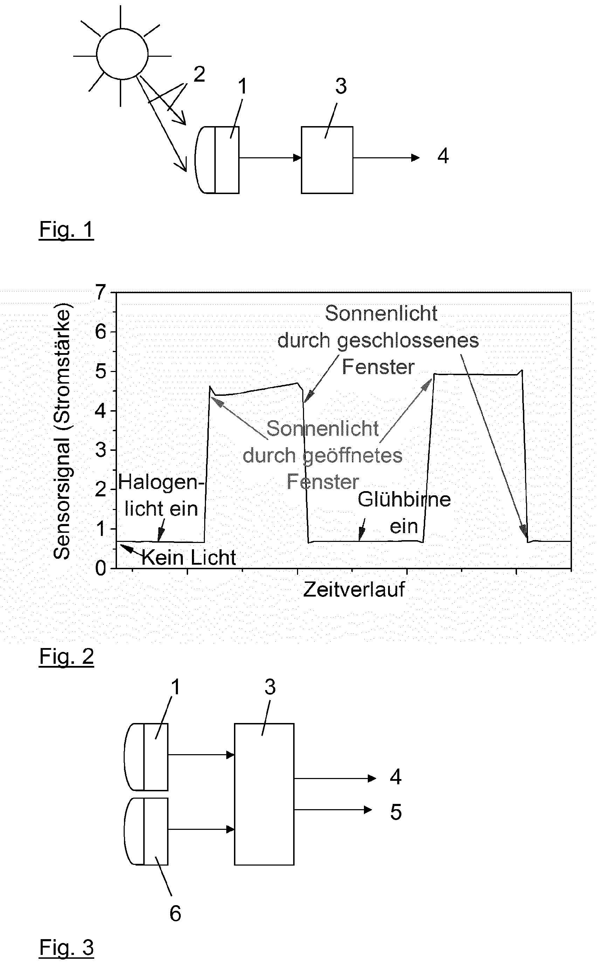

In Figur 1 ist stark schematisiert eine Detektoranordnung dargestellt, wie sie beim vorgeschlagenen Verfahren zur Detektion von Sonnenlicht eingesetzt werden kann. Die Detektoranordnung umfasst in diesem Beispiel einen SiC-Halbleiterdetektor 1, der aufgrund der Eigenschaften des Halbleitermaterials lediglich für den Wellenlängenbereich < 400 nm und somit für den UV-Anteil des Sonnenlichts empfindlich ist. Bei einfallendem Sonnenlicht 2 liefert dieser Detektor 1 ein Signal, welches in einer Auswerte- und Verstärkerschaltung 3 geeignet aufbereitet und als Ausgangssignal 4 der Detektoranordnung bereitgestellt wird. Die Höhe dieses Ausgangssignals 4 ist ein Maß für die Intensität der einfallenden Sonnenstrahlung.

Mit einem auf SiC basierenden Halbleiterdetektor, insbesondere einem 4H-SiC-Detektor, der einen sehr einfachen Aufbau aufweist, kann auch bei Streulichteinfall des Sonnenlichts oder zusätzlicher direkter oder indirekter Bestrahlung durch künstliche Lichtquellen das Vorhandensein von Sonneneinstrahlung zuverlässig detektiert werden. Darüber hinaus wird der Detektor auch nicht durch das durch ein Fenster einfallende Sonnenlicht gestört, da die im Gebäudebau üblichen Verglasungen das UV-Licht absorbieren. Durch die Auswertung des Messsignales des Detektors lässt sich dadurch ableiten, ob eine direkte bzw. indirekt durch Streulicht vorliegende Bestrahlung durch Sonnenlicht vorliegt. Darüber hinaus lässt sich die Bestrahlungsintensität bei Raumtemperatur präzise messen. In Kombination mit einem für den sichtbaren Spektralbereich empfindlichen Detektor, bspw. einem Siliziumdetektor, kann parallel auch die Bestrahlung durch Kunstlicht oder durch gefiltertes Sonnenlicht, bei dem der UV-Anteil herausgefiltert wurde, ermittelt werden. Dies wird weiter unten in Verbindung mit Figur 3 nochmals näher erläutert.

Figur 2 zeigt ein Beispiel für die Messung mit einem 4H-SiC-Halbleiterdetektor bei Einfall unterschiedlicher Lichtarten. Aus der Messung ist ersichtlich, dass künstliche Lichtquellen, wie Halogenlicht oder Glühlampenlicht kein über dem Messrauschen liegendes Messsignal liefern. Das Detektorsignal ohne Beleuchtung wird durch das Messrauschen dominiert (Dunkelleckstrom des Detektors).

Weder bei Bestrahlung durch eine Halogenlampe noch durch eine Glühbirne ergibt sich eine merkliche Änderung des Detektorsignals. Wird der Detektor direkter oder indirekter Sonneneinstrahlung ausgesetzt, steigt das Detektorsignal deutlich an. Erfolgt die Bestrahlung hingegen durch ein Fenster, sinkt das Detektorsignal wieder auf den Wert vor der Exposition durch direkte oder indirekte Sonneneinstrahlung. In diesem Beispiel wurde die Bestrahlung mit Sonnenlicht durch indirekte Bestrahlung des Detektors mit Sonnenlicht als Streulicht bestimmt, das durch ein geöffnetes Fenster an der Nordseite eines Gebäudes bei Bewölkung eingefallen ist.

Figur 3 zeigt stark schematisiert ein Beispiel für eine Detektoranordnung, bei der zusätzlich zum SiC-Halbleiterdetektor 1 ein im sichtbaren Spektralbereich empfindlicher Detektor 6 eingesetzt wird. Die Signale beider Detektoren werden in einer Auswerteschaltung 3 aufbereitet, um bei Detektion von direkt oder indirekt einfallendem Sonnenlicht, bei dem beide Detektoren ein Messsignal liefern, ein Ausgangssignal 4 bereitzustellen, das ein Maß für die Intensität des Sonnenlichts darstellt. Bei Detektion durch lediglich einen der beiden Detektoren wird demgegenüber ein entsprechendes Ausgangssignal 5 erzeugt. Damit kann die Störungsunempfindlichkeit des Verfahrens gegenüber anderen Lichtquellen nochmals erhöht werden. Für den Aufbau einer derartigen Detektoranordnung stehen die für Halbleiterbauelemente aus Silizium üblichen Verfahren der Aufbau- und Verbindungstechnik auch für Siliziumkarbid-Bauelemente zur Verfügung.

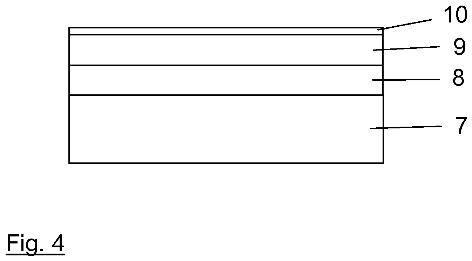

Figur 4 zeigt schließlich ein Beispiel für den Aufbau des eingesetzten SiC-Halbleiterdetektors in schematischer Darstellung. Die elektrischen Kontaktierungen an der Ober- und Unterseite des Detektors sind in dieser Figur nicht dargestellt. Der Detektor weist in diesem Beispiel ein vorzugsweise (hoch) n-dotiertes SiC-Halbleitersubstrat 7 auf, auf dem ein erstes dotiertes Halbleitergebiet 8 (als unteres Halbleitergebiet bezeichnet), ebenfalls bevorzugt n-dotiert, mit einer Dotierstoffkonzentration unter 5*10¹⁴ cm⁻³ aufgebracht oder eingebettet ist. Die Dicke des unteren Halbleitergebietes 8 beträgt mindestens 1,7pm. Auf diesem unteren Halbleitergebiet 8 ist eine zweites hoch-dotiertes Halbleitergebiet 9 (als oberes Halbleitergebiet bezeichnet), bevorzugt p+-dotiert, mit einer Dotierstoffkonzentration über 5*10¹⁸ cm⁻³ und einer Schichtdicke zwischen 1,5µm und 3µm aufgebracht. Vorzugsweise wird dieses obere Halbleitergebiet 9 mit einem Epitaxieprozess auf dem unteren Halbleitergebiet 8 abgeschieden. Diese beiden Halbleitergebiete 8, 9 bilden den pn-Übergang des Halbleiterdetektors. Auf dem oberen Halbleitergebiet 9 ist in diesem Beispiel eine Antireflexschicht 10 aus SiO₂ aufgebracht, die eine Dicke im Bereich von 50nm bis 66nm aufweist. Bevorzugt wird für diese Antireflexschicht ein Material gewählt, welches für Wellenlängenbereich unter 300nm nicht mehr (vollständig) transparent ist.

Das vorgeschlagene Verfahren, der zugehörige SiC-Halbleiterdetektor und die zugehörige Detektoranordnung können in den bereits in der Beschreibungseinleitung genannten Anwendungen für Kraftfahrzeuge eingesetzt werden. Damit werden bspw. für die Ansteuerung einer Klimaanlage Störungen durch andere Lichtquellen, wie Straßenbeleuchtungen oder die Beleuchtung in Tunneln, vermieden, die bspw. eine Fehlinformation bezüglich des Sonnenstands liefern würden. Auch eine Messung der Bestrahlung von lichtempfindlichen Objekten mit Sonnenlicht über einen längeren Zeitraum ist mit diesem Verfahren möglich. Die Messung wird auch hier nicht durch andere künstliche Lichtquellen verfälscht.

Eine weitere beispielhafte Anwendung stellt die kontaktlose Erfassung eines geöffneten Fensters bei Tageslicht dar. Im Gegensatz zu mechanischen Kontaktkreisen oder magnetischen (kontaktlosen) Überwachungsbauteilen, erlaubt die Lösung mit der vorgeschlagenen Detektoranordnung eine nahezu freie Positionierung im Gebäudeinnenraum, am oder abseits des zu überwachenden Fensters. Gerade bei Nutzung eines SiC-basierten Sonnenlichtdetektors kann aufgrund des geringen Leckstroms auch das durch einen Fensterspalt eindringende Streulicht des Sonnenspektrums zuverlässig detektiert werden, um zu entscheiden, ob ein Fenster geöffnet ist. Eine Störung durch andere Lichtquellen im Gebäude ist dadurch ausgeschlossen.

Auch eine ortsaufgelöste Sonnenlichtdetektion kann mit einer entsprechend ausgestalteten Detektoranordnung realisiert werden, bei der die einzelnen Detektoren zu einem Pixelsensor (identisch einer CCD-Kamera) zusammengesetzt sind, um die Position der Sonneneinstrahlung zu bestimmen. Auch hier ist eine Kombination mit einem für den sichtbaren Spektralbereich empfindlichen Detektorarray, bspw. einer Silizium-CCD-Kamera, möglich.

Selbstverständlich sind auch viele weitere Anwendungen möglich, bei denen Sonnenlichteinstrahlung detektiert werden soll, bspw. um die Wahrscheinlichkeit eines Fehlalarms oder einer Fehlinterpretation anderer Messungen durch Sonneneinstrahlung zu vermindern. Ein Beispiel ist die ortsaufgelöste Flammendetektion wie sie für die Triebwerkserfassung von Flugabwehrraketen eingesetzt wird. Hier kann durch den Abgleich von UV-Lichtanteil und Anteil des sichtbaren Lichts zwischen Sonnenlicht und Triebwerksemission unterschieden werden. Auch die Messung der Tageslänge ist für eine Reihe von kommerziellen Anwendungen relevant. So beeinflusst die Dauer der Tageslänge in der Pflanzenzucht den Blühzeitpunkt.

### Bezugszeichenliste

- 1: SiC-Halbleiterdetektor
- 2: Sonnenlicht
- 3: Auswerteschaltung
- 4: Ausgangssignal
- 5: weiteres Ausgangssignal
- 6: Detektor für sichtbaren Spektralbereich
- 7: SiC-Halbleitersubstrat
- 8: unteres Halbleitergebiet
- 9: oberes Halbleitergebiet
- 10: Antireflexschicht

## Patentansprüche

1. Verfahren zur Detektion von Sonnenlicht,
bei dem eine Detektoranordnung mit wenigstens einem SiC-Halbleiterdetektor eingesetzt wird, die nur für einen UV-Anteil von einfallendem Sonnenlicht sensitiv ist,
**dadurch gekennzeichnet,**
**dass** ein unteres (8) von zwei einen pn-Übergang bildenden Halbleitergebieten des SiC-Halbleiterdetektors eine Dotierstoffkonzentration von < 1*10¹⁵ cm⁻³ und eine Dicke aufweist, die größer als 50% der Weite der Raumladungszone im thermodynamischen Gleichgewicht bei nicht begrenzender Dicke dieses Halbleitergebietes (8) ist.

2. Verfahren nach Anspruch 1,
**dadurch gekennzeichnet,**
**dass** als der wenigstens eine SiC-Halbleiterdetektor (1) ein SiC-Halbleiterdetektor eingesetzt wird, bei dem die Dicke des unteren Halbleitergebietes (8) mindestens 1,7 µm beträgt.

3. Verfahren nach Anspruch 1 oder 2,
**dadurch gekennzeichnet,**
**dass** als der wenigstens eine SiC-Halbleiterdetektor (1) ein SiC-Halbleiterdetektor eingesetzt wird, bei dem die Dotierstoffkonzentration des unteren Halbleitergebietes (8) < 5*10¹⁴ cm⁻³ beträgt.

4. Verfahren nach einem der Ansprüche 1 bis 3,
**dadurch gekennzeichnet,**
**dass** als der wenigstens eine SiC-Halbleiterdetektor (1) ein SiC-Halbleiterdetektor eingesetzt wird, bei dem ein oberes (9) der zwei den pn-Übergang bildenden Halbleitergebiete eine Dicke zwischen 1,5 µm und 3 µm aufweist.

5. Verfahren nach Anspruch 4,
**dadurch gekennzeichnet,**
**dass** als der wenigstens eine SiC-Halbleiterdetektor (1) ein SiC-Halbleiterdetektor eingesetzt wird, bei dem das obere Halbleitergebiet (9) eine Dotierstoffkonzentration von > 5*10¹⁸ cm⁻³ aufweist.

6. Verfahren nach einem der Ansprüche 1 bis 5,
**dadurch gekennzeichnet,**
**dass** als der wenigstens eine SiC-Halbleiterdetektor (1) ein 4H-SiC-Halbleiterdetektor eingesetzt wird.

7. Verfahren nach einem der Ansprüche 1 bis 6,
**dadurch gekennzeichnet,**
**dass** eine Sperrspannung an den pn-übergang angelegt wird, durch die die Sensitivität des SiC-Halbleiterdetektors (1) im Wellenlängenbereich zwischen 330 und 380 nm erhöht wird.

8. Verfahren nach einem der Ansprüche 1 bis 7,
**dadurch gekennzeichnet,**
**dass** in der Detektoranordnung wenigstens ein zweiter Detektor (6) eingesetzt wird, der im sichtbaren Spektralbereich eine maximale Empfindlichkeit aufweist, wobei aus Ausgangssignalen des SiC-Halbleiterdetektors (1) und des zweiten Detektors (6) ermittelt wird, ob direkte Sonneneinstrahlung vorliegt oder ob Sonneneinstrahlung durch ein Fenster oder Einstrahlung einer nur im UV- oder nur im sichtbaren Spektralbereich emittierenden Lichtquelle vorliegt.

9. SiC-Halbleiterdetektor, bei dem ein unteres (8) von zwei einen pn-Übergang bildenden Halbleitergebieten eine Dotierstoffkonzentration von < 1*10¹⁵ cm⁻³ und eine Dicke aufweist, die größer als 50% der Weite der Raumladungszone im thermodynamischen Gleichgewicht bei nicht begrenzender Dicke dieses Halbleitergebietes ist.

10. SiC-Halbleiterdetektor nach Anspruch 9,
**dadurch gekennzeichnet,**
**dass** die Dotierstoffkonzentration des unteren Halbleitergebietes (8) < 5*10¹⁴ cm⁻³ beträgt.

11. SiC-Halbleiterdetektor nach Anspruch 9 oder 10,
**dadurch gekennzeichnet,**
**dass** die Dicke des unteren Halbleitergebietes (8) mindestens 1,7 µm beträgt.

12. SiC-Halbleiterdetektor nach einem der Ansprüche 9 bis 11, **dadurch gekennzeichnet,**
**dass** ein oberes (9) der zwei den pn-Übergang bildenden Halbleitergebiete eine Dicke zwischen 1,5 µm und 3 µm aufweist.

13. Verwendung eines SiC-Halbleiterdetektors nach einem der Ansprüche 9 bis 12 für die Steuerung der Klimaanlage in Kraftfahrzeugen.

14. Verwendung eines SiC-Halbleiterdetektors nach einem der Ansprüche 9 bis 12 für die Erfassung eines geöffneten Fensters in einem Raum.

15. Detektoranordnung zur Detektion von Sonnenlicht, die wenigstens einen SiC-Halbleiterdetektor nach einem der Ansprüche 9 bis 12 und wenigstens einen zweiten Detektor aufweist, der im sichtbaren Spektralbereich eine maximale Empfindlichkeit aufweist.

## Claims

1. A method for the detection of sunlight, in which a detector arrangement having at least one SiC-semiconductor detector is deployed, which is only sensitive to a UV-component of incident sunlight,
**characterised in that**
a lower (8) of two semiconductor regions forming a pn-junction of the SiC-semiconductor detector has a dopant concentration of < 1*10¹⁵ cm⁻³, and has a thickness that is greater than 50 % of the width of the space-charge zone in thermodynamic equilibrium, with thickness not restricting the space-charge zone of this semiconductor region (8).

2. The method according to claim 1,
**characterised in that**
as the at least one SiC-semiconductor detector (1), a SiC-semiconductor detector is deployed in which the thickness of the lower semiconductor region (8) is at least 1.7 µm.

3. The method according to claim 1 or 2,
**characterised in that**
as the at least one SiC-semiconductor detector (1), a SiC-semiconductor detector is deployed in which the dopant concentration of the lower semiconductor region (8) is < 5*10¹⁴ cm⁻³.

4. The method according to any one of the claims 1 to 3,
**characterised in that**
as the at least one SiC-semiconductor detector (1), a SiC-semiconductor detector is deployed in which an upper (9) of the two semiconductor regions forming the pn-junction has a thickness of between 1.5 µm and 3 µm.

5. The method according to claim 4,
**characterised in that**
as the at least one SiC-semiconductor detector (1), a SiC-semiconductor detector is deployed in which the upper semiconductor region (9) has a dopant concentration of > 5*10¹⁸ cm⁻³.

6. The method according to any one of the claims 1 to 5,
**characterised in that**
as the at least one SiC-semiconductor detector (1), a 4H-SiC-semiconductor detector is deployed.

7. The method according to any one of the claims 1 to 6,
**characterised in that**
a block voltage is applied on the pn-junction, by means of which the sensitivity of the SiC-semiconductor detector (1) is increased in the wavelength range between 330 and 380 nm.

8. The method according to any one of the claims 1 to 7,
**characterised in that**
in the detector arrangement at least one second detector (6) is deployed, which has a maximum sensitivity in the visible spectral range, wherein from output signals of the SiC-semiconductor detector (1) and the second detector (6) it is determined as to whether direct solar radiation is present, or whether solar radiation through a window, or radiation from a light source emitting only in the UV spectral range, or only in the visible spectral range, is present.

9. A SiC-semiconductor detector, in which a lower (8) of two semiconductor regions forming a pn-junction has a dopant concentration of < 1*10¹⁵ cm⁻³, and has a thickness that is greater than 50 % of the width of the space-charge zone in thermodynamic equilibrium, with thickness not restricting this semiconductor region.

10. The SiC-semiconductor detector according to claim 9,
**characterised in that**
the dopant concentration of the lower semiconductor region (8) is < 5*10¹⁴ cm⁻³.

11. The SiC-semiconductor detector according to claim 9 or 10,
**characterised in that**
the thickness of the lower semiconductor region (8) is at least 1.7 µm.

12. The SiC-semiconductor detector according to any one of the claims 9 to 11,
**characterised in that**
an upper (9) of the two semiconductor regions forming the pn-junction has a thickness of between 1.5 µm and 3 µm.

13. An application of a SiC-semiconductor detector according to any one of the claims 9 to 12 for the control of the air conditioning system in motor vehicles.

14. An application of a SiC-semiconductor detector according to any one of the claims 9 to 12 for the registration of an open window in a room.

15. A detector arrangement for the detection of sunlight that has at least one SiC-semiconductor detector according to any one of the claims 9 to 12, and at least one second detector, which has a maximum sensitivity in the visible spectral range.

## Revendications

1. Procédé de détection de la lumière solaire, dans lequel un dispositif de détecteur avec au moins un détecteur à semi-conducteurs SiC est employé, qui est uniquement sensible à une fraction UV de la lumière solaire incidente, **caractérisé en ce que** une région à semi-conducteurs inférieure (8) des deux régions à semi-conducteurs formant une transition pn du détecteur à semi-conducteurs SiC présente une concentration en dopant de < 1*10¹⁵ cm⁻³ et une épaisseur, qui est plus grande que 50 % de la largeur de la zone de charge d'espace en équilibre thermodynamique en cas d'épaisseur non limitée de cette région à semi-conducteurs.

2. Procédé selon la revendication 1, **caractérisé en ce que** un détecteur à semi-conducteurs SiC est employé comme au moins un détecteur à semi-conducteurs SiC (1), dans lequel l'épaisseur de la région à semi-conducteurs inférieure (8) s'élève au moins à 1,7 µm.

3. Procédé selon la revendication 1 ou 2, **caractérisé en ce que** un détecteur à semi-conducteurs SiC est employé comme au moins un détecteur à semi-conducteurs SiC (1), dans lequel la concentration en dopant de la région à semi-conducteurs inférieure (8) s'élève à < 5*10¹⁴ cm⁻³.

4. Procédé selon une des revendications 1 à 3,
**caractérisé en ce que** un détecteur à semi-conducteurs SiC est employé comme au moins un détecteur à semi-conducteurs SiC (1), dans lequel une région à semi-conducteurs supérieure (9) des deux régions à semi-conducteurs formant la transition pn présente une épaisseur comprise entre 1,5 µm et 3 µm.

5. Procédé selon la revendication 4, **caractérisé en ce que** un détecteur à semi-conducteurs SiC est employé comme au moins un détecteur à semi-conducteurs SiC (1), dans lequel la région à semi-conducteurs supérieure présente une concentration en dopant de > 5*10¹⁸ cm⁻³.

6. Procédé selon une des revendications 1 à 5,
**caractérisé en ce que** un détecteur à semi-conducteurs SiC 4H est employé comme au moins un détecteur à semi-conducteurs SiC (1).

7. Procédé selon une des revendications 1 à 6,
**caractérisé en ce que** une tension de blocage est appliquée sur la transition pn, au moyen de laquelle la sensibilité du détecteur à semi-conducteurs SiC (1) dans la plage de longueur d'onde entre 330 et 380 nm est augmentée.

8. Procédé selon une des revendications 1 à 7,
**caractérisé en ce que** dans le dispositif de détecteur au moins un deuxième détecteur (6) est employé, qui présente dans la plage spectrale visible une sensibilité maximale, dans lequel à partir des signaux de sortie du détecteur à semi-conducteurs SiC (1) et du deuxième détecteur (6), il est déterminé si un rayonnement solaire direct est présent ou si un rayonnement solaire à travers une fenêtre ou un rayonnement d'une source lumineuse émettant seulement dans la plage spectrale visible ou la plage spectrale UV est présent.

9. Détecteur à semi-conducteurs SiC, dans lequel une région à semi-conducteurs inférieure des deux régions à semi-conducteurs formant une transition pn présente une concentration en dopant de < 1*10¹⁵ cm⁻³ et une épaisseur, qui est plus grande que 50 % de la largeur de la zone de charge d'espace en équilibre thermodynamique en cas d'épaisseur non limitée de cette région à semi-conducteurs.

10. Détecteur à semi-conducteurs SiC selon la revendication 9, **caractérisé en ce que** la concentration en dopant de la région à semi-conducteurs inférieure (8) s'élève à < 5*10¹⁴ cm⁻³.

11. Détecteur à semi-conducteurs SiC selon la revendication 9 ou 10, **caractérisé en ce que** l'épaisseur de la région à semi-conducteurs inférieure (8) s'élève au moins à 1,7 µm.

12. Détecteur à semi-conducteurs SiC selon une des revendications 9 à 11, **caractérisé en ce que** une région à semi-conducteurs supérieure (9) des deux régions à semi-conducteurs formant la transition pn présente une épaisseur comprise entre 1,5 µm et 3 µm.

13. Utilisation d'un détecteur à semi-conducteurs SiC selon une des revendications 9 à 12 pour la commande de l'installation de climatisation dans des véhicules automobiles.

14. Utilisation d'un détecteur à semi-conducteurs SiC selon une des revendications 9 à 12 pour la détection d'une fenêtre ouverte dans un espace.

15. Dispositif de détecteur pour la détection de lumière solaire, qui présente au moins un détecteur à semi-conducteurs SiC selon une des revendications 9 à 12 et au moins un deuxième détecteur, qui présente dans la plage spectrale visible une sensibilité maximale.
